# DEMANDE DE BREVET EUROPEEN

(11) **EP 1 710 808 A2**
(43) Date de publication de la demande: **11.10.2006**
(21) Numéro de dépôt: 06368006.0
(22) Date de dépôt: 03.04.2006
(51) Int. Cl.: G11C 19/00, G11C 19/28

(54) **Circuit mémoire comportant une chaîne d'étages et procédé d'écriture/lecture d'un tel circuit**

(30) Priorité: 05.04.2005 FR 0503351
(71) Demandeur: STMicroelectronics SA, 92120 Montrouge (FR)
(72) Inventeur: Valencia Rissetto, Leonardo, 38330 Montbonnot (FR)
(74) Mandataire: Schuffenecker, Thierry

(57) **Abrégé**

Circuit mémoire comportant une chaîne d'étages élémentaires, chaque étage comportant une entrée (IN(i)), une sortie (OUT(i)) et une commande EN(i). Chaque étage comporte deux transistors MOS de même type connectés en série entre un premier potentiel (V_{cc}) et un second potentiel (Vₛₛ), le point milieu étant connecté à l'électrode de sortie dudit étage. La grille du premier transistor sert de commande de propagation de l'information à stocker tandis que la grille du second transistor sert de point d'entrée dans l'étage. Le circuit de mémoire comporte un codage particulier de l'information à stocker pour éviter que ne soit stocké deux 1 logiques (pour des transistors de type NMOS) au sein de la chaîne de stockage. L'invention porte également sur un procédé d'écriture et de lecture d'une telle mémoire.

## Description

### Domaine technique de l'invention

La présente invention concerne les circuits mémoires et notamment un circuit mémoire de type dynamique permettant une intégration dense.

### Etat de la technique

Le développement de l'information a entraîné un accroissement considérable en besoin de stockage de données.

L'état de la technique connaît d'innombrables circuits mémoires et notamment les mémoires volatiles. Avec l'accroissement des besoins de stockage de données dans toutes les applications courantes, il devient indispensable de pouvoir disposer d'une large gamme de circuits mémoires susceptibles de satisfaire de vastes besoins.

On distingue classiquement les mémoires en fonction de la nature du point mémoire. Dans les mémoires dites statiques, le point mémoire conserve l'information à stocker sans limitation de temps alors que dans une mémoire de type dynamique, la rétention de l'information n'est qu'éphémère et demande à être périodiquement rafraîchie. On classe également les circuits mémoires suivant l'architecture exploitant les points mémoires et, à cet égard, on distingue les mémoires à port simple, celles à double port, les mémoires de type FIFO (*First In First Out*) et également les registres à décalage (désignés sous l'appellation « *shift register* » dans la littérature anglo-saxonne).

Les applications modernes requièrent fréquemment des circuits mémoires à forte densité et, si possible, qui restent bon marché.

La miniaturisation constante des circuits électroniques permet déjà d'accroître la densité des circuits mémoires.

Pour autant, il reste souhaitable de pouvoir disposer de circuits mémoires ne nécessitant qu'un nombre réduit de transistors par point mémoire, et un arrangement ou micro architecture de ces transistors optimale. Ce qui permet également de contribuer à l'accroissement de la densité des circuits.

Les mémoires qui sont réalisées en matrices ou tableau ( ou *array* dans la littérature anglo-saxonne) sont un modèle très répandu car elles permettent un accès individuel a chacun des points mémoires au travers d'un adressage.

Les mémoires du type « *shift register* » ont une fonctionnalité restreinte par rapport aux précédentes mais présentent un potentiel d'intégration plus élevé, puisque l'on a diminué leur accessibilité et, par conséquent, les ressources nécessaires pour les implémenter.

C'est cette différence qui explique notamment la meilleure densité des mémoires non volatiles d'architecture NAND par rapport a celles du type NOR.

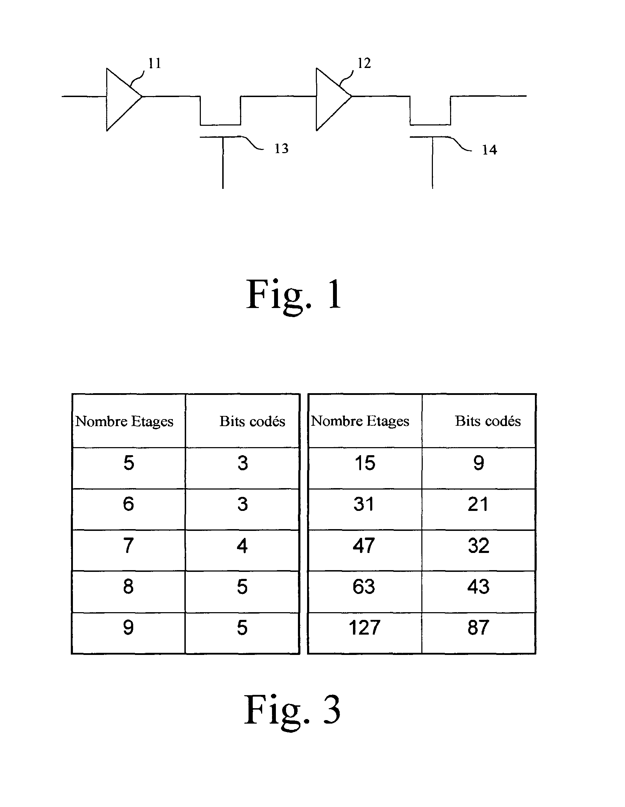

La figure 1 illustre une structure classique d'un circuit mémoire « *shift register »* ou registre à décalage , telle qu'on la connaît notamment dans l'art antérieur , et décrite dans le brevet US 5,806,084 . Une telle structure est basée sur un registre à décalage ou ligne à retard comportant une cascade d'éléments mémoires ou de circuit tampons (ou *buffer* dans la littérature anglo-saxonne) connectés les uns aux autres. La figure 1 illustre deux circuits tampons 11 et 12, généralement réalisés sous la forme d'un inverseur, et séparé par un transistor de commande de propagation 13 (resp. 14) servant à commander la propagation de la transmission de l'information d'un circuit tampon à l'autre. Le fonctionnement d'une telle mémoire est le suivant : lorsque le transistor de propagation 13 est fermé par exemple, l'étage 12 est alors connecté à l'étage précédent, ce qui provoque alors le transfert de cette valeur dans l'étage 12. Lorsque le transistor 13 est ouvert, l'étage 12 reste alors déconnecté et se comporte alors comme un point de rétention de l'information susceptible de conserver cette information pendant une certaine durée qui est fonction de la valeur de la capacité interne de l'étage.

On constate, sur le schéma de la figure 1, que la structure connue requiert un ensemble de trois transistors par étage élémentaires, et dont deux notamment sont de type opposés En effet, on rappèle qu'un circuit inverseur est classiquement réalisé au moyen de deux transistors MOS de type opposés (P et N) présentant chacun des sources et des drains spécifiques.

C'est une limite à l'accroissement de la densité et il est souhaitable de pouvoir remédier à cet inconvénients et de réduire davantage l'encombrement requis par un étage élémentaire.

Tel est l'objet de la présente demande de brevet.

### Exposé de l'invention

La présente invention a pour but de proposer une nouvelle structure de circuit mémoire basée sur une cascade d'étages faciles à intégrer et ne présentant que peu de composants.

C'est un autre objet de la présente invention que de réaliser un circuit mémoire pour une mémoire volatile particulièrement dense à intégrer et bon marché à fabriquer.

L'invention réalise ces buts au moyen d'un circuit mémoire comportant une chaîne d'étages élémentaires disposant chacun d'une entrée IN(i)) , une sortie OUT(i) et une commande EN(i). Chaque étage comporte deux transistors NMOS qui sont connectés en série entre un premier potentiel (V_{cc}) et un second potentiel (Vₛₛ), le point milieu étant connecté à l'électrode de sortie dudit étage. La grille du premier transistor sert de commande de propagation de l'information à stocker tandis que la grille du second transistor sert de point d'entrée dans l'étage. Le circuit de mémoire comporte un codage particulier de l'information à stocker pour éviter que ne soit stocké deux 1 logiques consécutifs dans la chaîne de stockage. L'invention porte également sur un procédé d'écriture et de lecture d'une telle mémoire.

On constate que, moyennant l'utilisation de ce code spécifique interdisant la succession de deux « 1 » logique au sein de la mémoire , on peut réaliser chaque étage au moyen de deux transistors MOS d'un même type, par exemple N.

En outre, ces deux transistors étant de même type, on pourra ainsi réduire de manière significative l'espace occupé par ces derniers, et même partager les mêmes substrats pour réaliser les sources et drains des deux transistors d'un même étage.

L'invention réalise également un circuit mémoire constitué d'une cascade d'étages constitués chacun de deux transistors de type PMOS connectés en série entre deux potentiels Vcc et Vss. Un premier transistor comporte une grille recevant le signal d'entrée IN(i) qui est le signal de sortie de l'étage précédent tandis qu'un second transistor recoit un signal de commande de propagation EN(i) permettant la commande de propagation de l'information à stocker. Le circuit comporte un codage particulier de l'information pour éviter que ne soit stocké deux 0 logique consécutifs dans la même chaîne de stockage.

Une logique de commande permet la génération de la cascade de signaux EN(i) de manière à venir positionner un bit d'information présenté en entrée de la chaîne à un étage donnée dans ladite chaîne d'étages.

Dans un mode de réalisation préféré, le circuit mémoire comporte en outre un circuit multiplexeur disposant d'une première entrée recevant l'information à stocker et d'une seconde entrée recevant la sortie du dernier étage de ladite chaîne d'étages et d'une entrée de commande permettant de commander une opération de décalage d'une information stockée dans ladite chaîne en boucle ouverte ou fermée.

De préférence, on organisera plusieurs chaînes de stockage en parallèle commandées simultanément par les mêmes signaux de commande EN(i), EN(i+1).

L'invention a également pour objet la réalisation d'un procédé d'écriture dans un circuit mémoire tel que défini précédemment, comportant des blocs d'étages correspondant à la longueur d'un code donné, ledit code assurant le codage de l'information à stocker dans ladite chaîne de manière à exclure deux 1 logiques consécutifs.
Le procédé d'écriture comportant les étapes suivantes :
- codage de l'information à stocker dans ledit circuit suivant le dit code,
- présentation d'un bit de l'information à stocker dans ledit circuit, sous sa forme vraie ou inversée selon son rang pair ou impair ;
- commande du signal EN(i) de chaque étage dudit circuit de manière à venir successivement positionner chaque bit d'information à un étage particulier du premier bloc ;
- opérations successive de décalage permettant de déplacer l'information d'un bloc à un autre bloc.

Corrélativement, l'invention réalise un procédé de lecture dans un circuit mémoire comportant des blocs d'étages correspondant à la longueur d'un code donné. Le code assurant le codage de l'information à stocker dans ladite chaîne de manière à exclure deux 1 logiques consécutifs. Le procédé comporte les étapes suivantes :
- une ou plusieurs opérations de décalage de l'information d'un bloc à un autre de manière à venir présenter l'information à lire dans le dernier bloc dudit circuit mémoire ;
- commande du signal EN(i) de chaque étage dudit circuit de manière à venir successivement lire chaque bit d'information en sortie dudit circuit mémoire ;
- inversion des bits de rang impair ;
- décodage de l'information de manière à restituer l'information originelle.
   L'invention est particulièrement adaptée à la réalisation d'une mémoire de type FIFO.

### Description des dessins

D'autres caractéristiques, but et avantages de l'invention apparaîtront à la lecture de la description et des dessins ci-après, donnés uniquement à titre d'exemples non limitatifs. Sur les dessins annexés :
La figure 1 illustre une structure série d'un circuit mémoire connu.
La figure 2a représente illustre le schéma de principe d'un point mémoire dans un circuit selon la présente invention réalisé au moyen de transistors de type NMOS.
La figure 2b représente illustre le schéma de principe d'un point mémoire dans un circuit selon la présente invention réalisé au moyen de transistors de type PMOS..
La figure 3 indique les correspondances entre le nombre d'étages du circuit mémoire selon l'invention et le nombre de bits stockés dans cette même structure.
La figure 4 illustre la courbe de densité d'une mémoire conforme à la présente invention en fonction du nombre d'étages la constituant.
La figure 5 illustre un groupe de huit étages utilisés pour stocker la valeur codée 01001010 , chaque étage étant représenté par un symbole d'inverseur avec une commande.
La figure 6 illustre le procédé de d'enregistrement et de déplacement d'un groupe de données.
La figure 7 illustre un circuit mémoire selon la présente invention.
La figure 8 illustre l'architecture générale d'un circuit mémoire comportant une mise en parallèle de chaînes distinctes.

### Description d'un mode de réalisation préféré

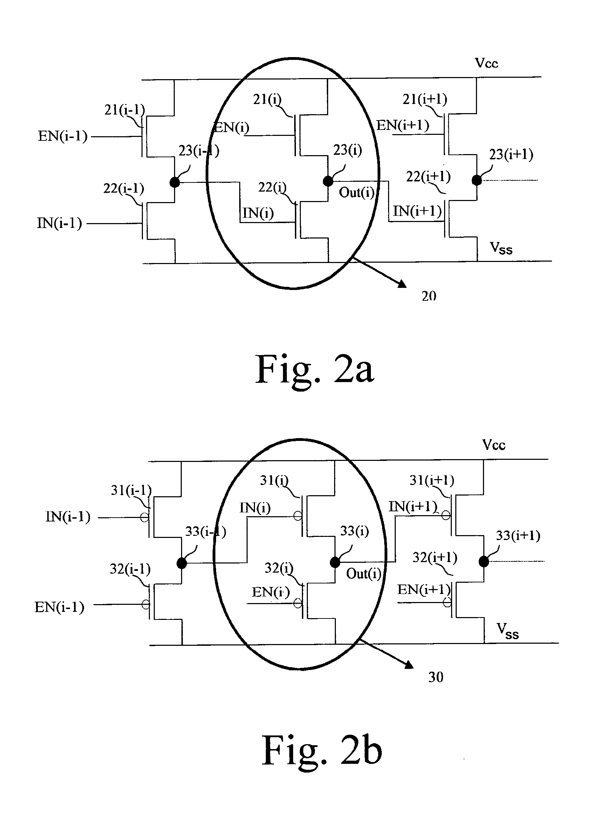

On décrit à présent, en relation avec la figure 2a , un mode de réalisation d'un circuit mémoire conforme à la présente invention réalisé au moyen de transistors de type NMOS.

Le circuit comporte, comme pour le circuit connu de la figure 1, un registre à décalage ou chaîne de stockage comportant une cascade d'étages élémentaires, tel que l'élément identifié sous la référence 20. L'étage 20 comporte un ensemble de deux transistors NMOS 21(i) et 22(i) dont les sources et drains sont connectés en série entre un premier potentiel de référence V_{cc} et un second potentiel de référence Vₛₛ. Le transistor 22(i) dispose d'une source connectée au potentiel Vₛₛ tandis que le drain du transistor 21 (i) est connecté au potentiel V_{cc}. La grille du transistor 21 (i) reçoit un potentiel de commande EN(i) ( ou *ENABLE* selon la littérature anglo-saxonne) tandis que la grille du transistor 22(i) est connectée à la sortie de l'étage précédent et reçoit le signal IN(i). L'électrode commune 23(i) entre les deux transistors 21 (i) et 22(i) génère le signal de sortie de l'étage 20 qui est transmis à l'étage en aval. Par souci de clarté, on a représenté sur le schéma de la figure 2 l'étage en amont ainsi que l'étage en aval de l'étage 20. Comme on le voit, l'étage en amont comporte deux transistors NMOS 21(i-1) et 22-(i-1) dont les sources et drains sont connectés en série entre les deux potentiels V_{cc} et Vₛₛ, et dont l'électrode commune 23(i-1) est connectée à la grille du transistor 22(i) de l'étage 20. S'agissant de l'étage en aval, ce dernier se compose des transistors NMOS 21(i+1) et 22 (i+1) connectés en série entre les deux potentiels V_{cc} et Vₛₛ, et l'électrode commune 23(i+1) est connectée à la grille du transistor suivant (non représenté).

Le schéma de la figure 2a comporte ainsi une cascade d'étages élémentaires, tous identiques à l'étage 20, qui sont connectés les uns aux autres. Le tout constitue ainsi un registre à décalage ou ligne à retard que présentait déjà le circuit connu de la figure 1. En revanche, contrairement au circuit de la figure 1, chaque étage est composé de deux transistors uniquement qui, de surcroît, sont de même type.

Il s'agit ici d'une différentielle considérable qui, si elle modifie considérablement le fonctionnement de chaque étage, apporte néanmoins des avantages significatifs.

En premier lieu, il n'y a pas besoin d'un composant équivalent au transistor de commande de propagation 13 ou 14 de la figure 1.

En second lieu, l'utilisation de deux transistors de même type permet de réduire la surface allouée à l'étage élémentaire sur le substrat de silicium. En effet, l'homme du métier notera que les deux transistors pourront fort opportunément être disposés de manière très proche sur un même substrat de silicium puisqu'ils relèveront d'un même type, à savoir P ou N. En outre, on notera avec intérêt que l'on pourra même partager les sources et drains des deux transistors d'un même étage, ce qui permet alors de les rapprocher au maximum sur le substrat de silicium.

L'invention permet ainsi la constitution d'une structure de mémoire particulièrement dense. En comparaison, un étage inverseur comportant deux transistors MOS de type N et P respectivement, occuperait une surface approximativement égale à quatre fois la surface d'un seul transistor MOS , alors que l'emprise de l'étage élémentaire de la figure 1 se limite à environ deux transistors seulement.

C'est là un avantage considérable lorsque l'on cherche à intégrer un grand nombre de points mémoires dans un substrat semi-conducteur.

On va décrire à présent le fonctionnement de la ligne à retard illustrées dans la figure 1 et on adoptera, dans un souci de clarté , une convention visant à associer un « 1 » logique stocké au sein d'un étage avec un potentiel positif proche de Vcc. Clairement il ne s'agit que d'un choix arbitraire et l'on aurait pu considérer une logique inverse.

La remarque fondamentale à faire sur le circuit de la figure 1 est de constater que, si les électrodes de grilles des transistors 21(i-1), 21(i), 21(i+1) etc - à savoir les signaux EN(i-1), EN(i), EN(i+1) permettent un contrôle de propagation au sein de la ligne à retard, ce contrôle n'est cependant pas complet.

Le fonctionnement logique de l'étage 20 est en effet le suivant :
Si IN(i) = 1 et EN(i) = 1, alors la sortie OUT (i) = 0
Si IN(i) = 0 et EN(i) = 1, alors la sortie OUT (i) = 1
Si IN(i) = 0 et EN(i) = 0, alors la sortie OUT (i) est en rétention
Si IN(i) = 1 et EN(i) = 0, alors la sortie OUT (i) = 0

Lorsque les deux signaux IN(i) et EN(i) sont égaux à 1 (proche du potentiel positif V_{cc}), le transistors 21 (i) conduit moins parfaitement que le transistor 22(i) et, par conséquent, le potentiel de sortie sur l'électrode commune de ces deux transistors est un 0 logique.

Lorsque les deux signaux IN(i) et EN(i) sont dans un état logique 0 (proche de la masse Vₛₛ), alors l'étage 20 se trouve dans un état de rétention d'information et le potentiel de sortie est celui fixé par la valeur précédente. Cette valeur précédente est conservée pendant un temps qui est déterminé par la valeur des capacités internes des deux transistors.

L'étage 20 se comporte donc, lorsque EN(i) = 1, comme un inverseur par rapport à IN(i) et, lorsque le couple EN(i), IN(i) est égal à (0,0) comme un point de rétention d'un bit d'information.

On constate donc que l'ensemble des étages, comportant l'étage 20 ainsi que les étages en amont et ceux en aval, réalise un registre à décalage ou une ligne à retard présentant la fonction d'une chaîne de stockage dont la propagation est imparfaitement commandée par les signaux de commande EN(i) : lorsque IN(i) = 0, la commande EN(i) permet la commande de la propagation de ce signal 0. En revanche, le signal IN(i) = 1 est propagé indifféremment de la valeur prise par la commande EN(0).

Il résulte de cette observation que l'on ne peut directement utiliser la ligne à retard de la figure 2a pour stocker n'importe quelle séquence car, même en fixant EN(i) = 0 pour toutes les valeurs de i, les bits qui seront fixés à « 1 » dans un étage donné seront automatiquement répercutés à l'entrée de l'étage suivant et viendront y écraser la valeur stockée si celle-ci n'est pas un « 0 ».

L'invention remédie à ce problème au moyen d'un codage spécifique de l'information visant à assurer qu'un « 1 » logique est toujours suivi d'un « 0 » ou, en d'autres termes, à exclure la présence de deux 1 logiques consécutifs dans la chaîne de stockage.

Moyennant cette contrainte sur le codage, il devient à présent possible de réaliser une ligne à retard complète réalisant la fonction d'une chaîne de stockage, composée de n étages , permettant un stockage d'une information en réponse à des signaux de commande EN(i) pour i = 0 à n.

Le choix du code est arbitraire dès lors qu'il respecte la contrainte d'éviter deux 1 successifs dans la chaîne de stockage. Si l'on considère par exemple des mots de quatre bits seulement, on observera que les seuls mots pouvant être stockés au sein de la chaîne de stockage sont « 1010 », « 1000 », « 0100 », et « 0010 ». En revanche, les mots suivants «1100 », « 0110 », « 0011 » ,« 0001 » ,« 1110 » ,« 0111 » ,« 1101 » ,« 1011 » ,« 0101 » ,« 1001 » ,« 0001 »et « 1111 » ne pourront être stockés.

Le codage le plus simple consiste donc, pour un nombre d'étages donné au sein de la chaîne, à identifier tous les mots qui ne peuvent être stockés dans cette même chaîne en raison de la propagation systématique des « 1 » logique. Une fois identifiés les mots pouvant être stockés au sein de la chaîne de stockage, il suffira alors de réaliser une conversion ou translation entre l'information d'origine à stocker - qui pourra être quelconque - et l'information codée (avec la contrainte mentionée précédemment) qui devra être stockée au sein de la chaîne de stockage et ce en tenant compte des inversions opérées en passant d'un étage à un autre.

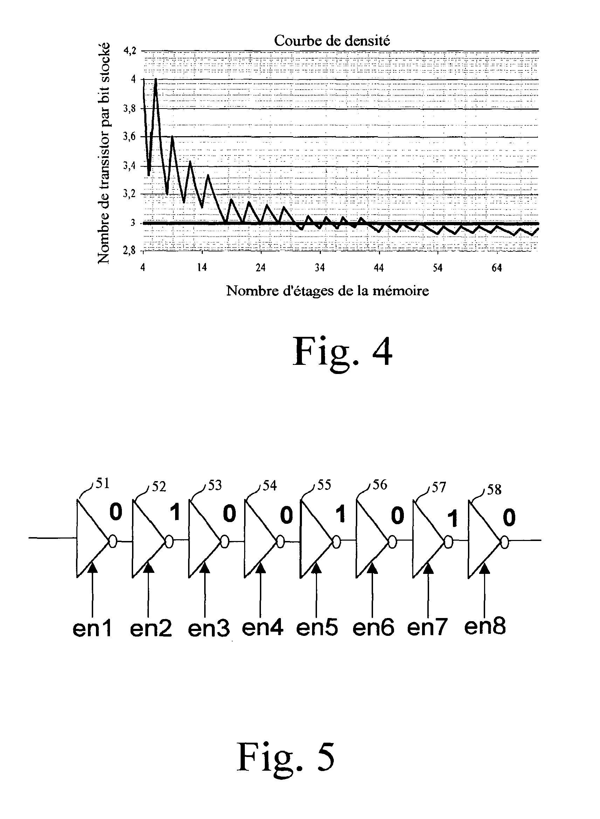

La figure 3 donne une correspondance entre le nombre de bits pouvant être codés et le nombre d'étages considérés au sein de la chaîne de stockage. On constate ainsi que, pour une chaîne de stockage comportant cinq étages seulement, on ne pourra stocker qu'une information codée sur trois bits uniquement. Lorsque le nombre d'étages augmente, le nombre de bits d'information pouvant être stocké augmente considérablement, et cela permet d'accroître la courbe de densité représentative du nombre de transistors par étage, comme cela apparaît sur la courbe illustrée dans la figure 4. On constate qu'à partir d'un nombre de 40-50 étages, cette courbe passe sous la valeur théorique de 3 transistors par étage ce qui montre que la chaîne de stockage selon l'invention, moyennant l'intervention du codage mentionné précédemment, permet de stocker plus que le circuit connu de la figure 1.

C'est déjà un avantage clairement identifié de l'invention.

En outre, la surface allouée sur le substrat de silicium est particulièrement réduite du fait que chaque étage est composé de deux transistors de même type, par exemple deux transistors NMOS. C'est un avantage considérable si l'on rappelle que, en moyenne, un ensemble de deux transistors NMOS et PMOS occupe une surface près de deux fois supérieure à la surface prise par deux transistors de type NMOS seulement.

On va à présent brièvement reprendre l'exposé dans le cas d'une implémentation réalisée au moyen de transistors de type PMOS.

La figure 2b illustre une telle réalisation. Les éléments 20, 21, 22 et 23 sont alors respectivement désignés sous les références 30, 31, 32 et 33r. On reprendra brièvement l'exposé de la structure en notant les différences. L'étage 30 comporte deux transistors PMOS 31 (i) et 32(i) dont les sources et drains sont respectivement connectés au potentiel V_{cc} et au potentiel Vₛₛ. Le transistor 31 (i) dispose d'une source connectée au potentiel V_{cc} tandis que le drain du transistor 32(i) est connecté au potentiel Vₛₛ. Le drain du transistor 31 (i) et la source dudit transistor 32(i) sont connectés à la sortie OUT(i) 33(i). La grille du transistor 32(i) reçoit un potentiel de commande EN(i) tandis que la grille du transistor 31 (i) est connectée à la sortie de l'étage précédent et reçoit le signal IN(i). L'électrode commune 33(i) entre les deux transistors 31 (i) et 32(i) génère le signal de sortie de l'étage 30 qui est transmis à l'étage en aval.

De la même manière que pour la structure réalisé au moyen de transistors NMOS, l'étage en amont comporte un transistor PMOS 31(i-1) et un transistor PMOS 32(i-1) dont les grilles reçoivent respectivement les signaux IN(i-1) et EN(i-1). Le transistor 31(i-1) comporte une source connectée au potentiel V_{cc} et un drain connecté à l'électrode de sortie de l'étage amont 33(i). Le transistor 32 (i-1) comporte un drain conencté au potentiel Vₛₛ et une source connecté à l'électrode de sortie 33(i).

Enfin, s'agissant de l'étage en aval, celui se compose d'un transistor PMOS 31(i+1) et d'un transistor PMOS 32(i+1) dont les grilles reçoivent respectivement les signaux IN(i+1) et EN(i+1). Le transistor 31(i+1) comporte une source connectée au potentiel V_{cc} et un drain connecté à l'électrode de sortie de l'étage amont 33(i+1). Le transistor 32 (i+1) comporte un drain connecté au potentiel Vₛₛ et une source connecté à l'électrode de sortie 33(i).

On constate que dans la structure de la figure 2b, le signal de commande EN(i) permet à présent, lorsqu'il est dans un niveau logique « 0 » , d'assurer la propagation du « 1 » logique conformément à la table de vérité suivante:
Si IN(i) = 0 et EN(i) = 0, alors la sortie OUT (i) = 1
Si IN(i) = 1 et EN(i) = 0, alors la sortie OUT (i) = 0 (propagation commandée par En(i)
Si IN(i) = 0 et EN(i) = 1, alors la sortie OUT (i) = 1 (propagation)
Si IN(i) = 1 et EN(i) = 1, alors la sortie OUT (i) est en rétention

On constate donc, dans cette réalisation duale de la structure de la figure 2a, que c'est à présent la propagation des «0 » qui ne peut être commandée par le signal de commande En(i) et qu'il faut à présent un codage de l'information évitant la présence de deux « 0 » consécutifs au sein de la chaîne de stockage.

Dans la suite des développements on considérera que chaque étage élémentaire est composé de deux transistors de type NMOS et que, par conséquent, le potentiel V_{cc} est un potentiel positif et que le potentiel Vₛₛ est un potentiel négatif ou la masse. Clairement, un homme du métier pourra adapter la suite des développements à la réalisation d'une ligne à retard basée sur des transistors de type PMOS et, par conséquent, la réalisation d'une structure mémoire comportant ce type de transistors.

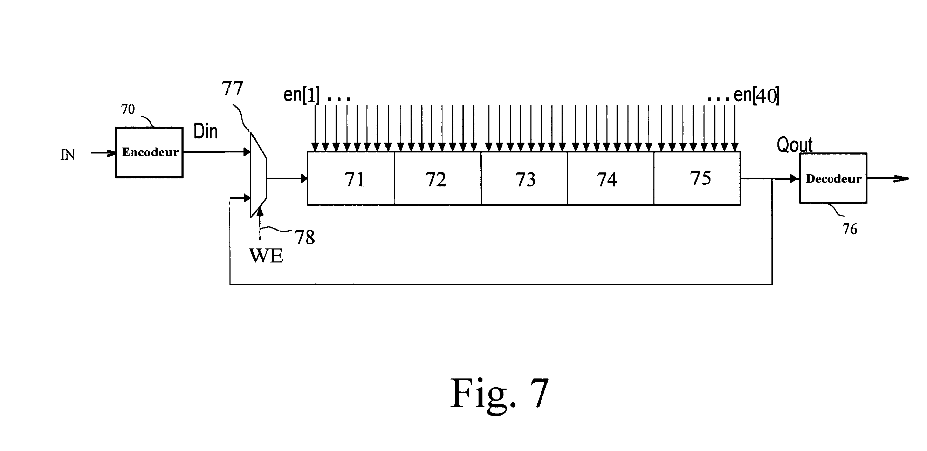

La figure 7 illustre un circuit mémoire élémentaire comportant une unique chaîne de stockage telle que décrite précédemment. Pour la commodité de l'exposé, on supposera que la chaîne de stockage est composée de 40 étages et que le code choisi est un code de 8 bits permettant de stocker cinq bits utiles. La mémoire est par conséquent divisée en cinq groupes, respectivement 71, 72, 73, 74 et 75, comportant chacun huit étages élémentaires tels que décrits précédemment en relation avec la figure 2. Le groupe 71 se compose de huit étages (également illustré par les éléments 51-58 de la figure 5) recevant respectivement les signaux de propagation EN(1), EN(2) .... EN(8). D'une manière similaire, le groupe 72 comporte huit étages recevant les signaux EN(9)-EN(16) etc

Le circuit mémoire de la figure 7 comporte un circuit encodeur 70 ayant une entrée recevant l'information à stocker sous forme série. L'encodeur 70 dispose d'une sortie Din qui est connectée à une première entrée d'un multiplexeur 77 dont la sortie est connectée à l'entrée de la chaîne de stockage 71-75, et plus précisément à l'entrée du premier étage du premier bloc composant cette chaîne. Cette même chaîne de stockage dispose d'une sortie - qui est la sortie du quarantième étage - laquelle est connectée à une seconde entrée du multiplexeur 77 ainsi qu'à une entrée du circuit décodeur 76 destiné à réaliser l'opération de décodage inverse de l'opération de codage effectuée par l'encodeur 70.

En sortie du décodeur 76, on retrouve l'information série initialement introduite dans la mémoire.

Le multiplexeur 77 est commandé par un signal WE ( *Write Enable* dans la littérature anglo-saxonne) qui permet de déterminer si c'est la sortie de l'encodeur 70 ou de la chaîne de stockage 71-75 qui est réinjectée à l'entrée de cette même chaîne.

On décrit à présent le fonctionnement de la chaîne de stockage selon l'invention, laquelle passe par un procédé comportant des phases d'écriture (1), de décalage de bloc (2) et de lecture (3).

### 1. Phase d'écriture

Considérons dans un premier temps l'opération d'écriture au sein du groupe 71 de la chaîne de stockage 71-75, et plus particulièrement le stockage d'une information qui, une fois encodée par l'encodeur 70 est « 01001010 » . Cette séquence de niveaux logiques correspond au contenu réellement dans la cascade de huit étages 51-58 (supposés de type N) le constituant, tel qu'illustré dans la figure 5.

A cet effet, on vient introduire à l'entrée de la chaîne de stockage une information Din au moyen du multiplexeur 77 commandé par un signal logique WE=1. En tenant compte des inversions produites à chaque rang impair de la chaîne de stockage, on vient donc présenter, à l'entrée du multiplexeur 77 une information Din est égale à :
Din = 1110000

Correspondant à une valeur b₁ b₂ b₃ b₄ b₅ b₆ b₇ b₈ = 01001010 effectivement stockée dans la chaîne de stockage.

L'écriture des bits b₁ b₂ b₃ b₄ b₅ b₆ b₇ b₈ dans la chaîne de stockage est réalisée au moyen de huit opérations élémentaires permettant de venir positionner successivement, l'entrée du multiplexeur 77, chacun des bits de l'information Din = 1110000

Dans un premier temps, on effectue d'abord le stockage du bit b₈ = 0 au sein de l'étage 58. A cet effet, on positionne les signaux de commande EN(1)-EN(8) à 1 et l'on présente la valeur de b8 à l'entrée du bloc 71 de manière à permettre la propagation de l'information jusqu'à la huitième position du bloc 71.

Dans un deuxième temps, on fixe les valeurs EN(1)-EN(7) à 1 et on vient ensuite présenter la valeur inverse de b₇ à l'entrée du bloc 71 de huit registres 51-58. Cette valeur inverse permet alors le stockage de la valeur b₇ au sein de l'étage 57 puisque l'information traverse un nombre impair d'inverseurs. On notera que si l'information stockée dans l'étage 57 est un « 1 » logique, cela signifie que cette valeur va automatiquement se propager jusqu'à l'étage suivant et y rafraîchir « 0 » logique qui s'y trouvait déjà stocké puisque le code utilisé exclut la présence de deux « 1 « logiques consécutifs. Si la valeur stockée dans l'étage 57 est un « 0 », alors la propagation de cette valeur est automatiquement stoppée puisque, par hypothèse, la commande EN(8) est fixée à un état bas.

On procède ensuite de manière similaire pour venir stocker successivement chacun des six bits b₁ b₂ b₃ b₄ b₅ b₆ dans les étages 51-56 lui correspondant et ce, au moyen d'une commande des signaux EN(1)-EN(8) assurant le bon positionnement de chaque bit d'information à sa juste place.

L'opération d'écriture s'achève avec le stockage du dernier bit b₁. A ce moment nous avons alors stocke dans les huit étages 51-58 les huits bits b1 b2 b3 b4 b5 b6 b7 b8

Comme on le voit, le procédé d'écriture qui vient d'être décrit permet donc le stockage d'une information codée au moyen des étapes décrites :
- codage de l'information à stocker dans ledit circuit suivant le dit code,
- génération d'une information Din présentée à l'entrée de la chaîne de stockage introduisant une inversion selon le rang pair ou impair ;
- présentation de l'information Din à l'entrée de la chaîne de stockage ;
- commande du signal EN(i) de chaque étage dudit circuit de manière à venir successivement positionner chaque bit d'information à un étage particulier du premier bloc ;
- opérations successive de décalage permettant de déplacer l'information d'un bloc à un autre bloc.

### 2. Phases de décalage.

Une fois l'opération d'écriture effectuée, le procédé poursuit avec une ou plusieurs opérations de décalage interne au sein de la chaîne de stockage afin de venir décaler le contenu du premier bloc 71 (comportant les étages 51-58) dans le bloc 72 de manière à venir libérer le bloc 71 pour permettre une opération ultérieure d'écriture dans ce même bloc.

Dans un mode de réalisation préféré, cette opération de décalage interne est réalisée en maintenant la boucle ouverte (ou OLS *Open Loop Shift*) suivant, c'est à dire en maintenant la commande du multiplexeur 77 à un niveau logique 1.

Le procédé effectue ensuite un séquencement de signaux EN(9)-EN(16) de manière à venir positionner, successivement, chacun des bits b₁ b₂ b₃ b₄ b₅ b₆ b₇ b₈ à leur place respective au sein du bloc 72. Pour la clarté de l'exposé, on reprendra brièvement les opérations successives :
Dans une première étape, le procédé génère un 1 logique sur les signaux de commande EN(9)-EN(16), ce qui entraîne automatiquement le transfert du contenu de l'étage 58 (à savoir b₈) dans le huitième étage du bloc 72.
Dans une seconde étape, le procédé génère un 1 logique sur les signaux de commande EN(8)-EN(15), ce qui entraîne automatiquement le transfert du contenu de l'étage 57 (à savoir b₇) dans le septième étage du bloc 73.

On poursuit ainsi successivement le transfert de chacun des étages 51-58 au moyen d'une commande appropriée sur les signaux EN(1)-EN(16). Il est à noter que, contrairement au procédé d'écriture décrit précédemment, il n'y a plus besoin de prévoir une inversion de données puisque, en passant d'un bloc à l'autre (du bloc 71 au bloc 72 dans notre exemple), chacun des bits b₁ b₂ b₃ b₄ b₅ b₆ b₇ b₈ conserve le même rang au sein du bloc.

Comme on le voit, l'opération de décalage peut être réalisée très simplement et cela permet d'effectuer un décalage du bloc 71 vers le bloc 72 .

On pourra de même effectuer de la même manière tout décalage interne au sein de la chaîne de stockage 71-75 de la figure 7.

La phase de décalage pourra également être une phase de décalage en boucle fermée, laquelle est réalisée en venant simplement commuter la commande du multiplexeur 77 au moyen du signal de commande WE (78).

Dans cette phase de décalage en boucle fermée (ou CLS *Closed Loop Shift*), le procédé effectue un transfert du contenu du dernier bloc 75 à l'intérieur du premier bloc 71 afin de permettre une éventuelle permutation circulaire au sein de la chaîne de stockage.

Ce transfert est réalisé au moyen de huit opérations successives de transfert de chacun des huit bits stockés dans le bloc 75 et ce, en venant commander de manière appropriée les signaux En(33)-EN(40) mais également les signaux EN(1)-EN(8).

### 3. Phase de lecture

L'opération de lecture est une opération similaire à un décalage en boucle ouverte puisqu'il suffit de réaliser un tel décalage sur le dernier bloc de la chaîne, à savoir le bloc 75. On permet ainsi la présentation successive, en sortie du dernier étage du bloc 75, de chacun des bits b₁ b₂ b₃ b₄ b₅ b₆ b₇ b₈ qui avaient été initialement stockés au sein de la chaîne de stockage.

A cet effet, on effectue d'abord la lecture du huitième étage du bloc 75 , ce qui se fait directement. Cette valeur b₈ est ensuite transmise au décodeur 76.

Dans un second temps, on effectue le transfert du contenu du septième étage du bloc 75 (à savoir b₇) dans le huitième étage de ce même bloc, et ce en venant activer le signal EN(40).

Dans un troisième temps, on réalise le transfert du contenu du sixième étage du bloc 75 dans le huitième étage de ce même bloc, et ce en procédant à l'activation des signaux EN(39)-EN(40). La valeur b₇ est ensuite transmise au décodeur 76.

On procède ainsi de suite jusqu'à la lecture des huit bits stockés b₁ b₂ b₃ b₄ b₅ b₆ b₇ b₈ . Une fois la lecture accomplie, la donnée est transmise au décodeur 76 qui effectue ensuite le décodage de cette valeur lue en tenant compte des inversions à effectuer sur les bits de rang impair et du code employé pour exclure la présence de deux 1 consécutifs au sein de la chaîne de stockage 71-75.

On notera que les opérations d'écriture, de lecture et de décalage interne participent toutes au rafraîchissement des points mémoires de la chaîne 71-75. C'est un autre effet particulièrement avantageux de l'invention de permettre, sans mécanisme additionnel classiquement requis pour les DRAM par exemple, un rafraîchissement automatique des points mémoires.

On notera également que l'information a lire a déjà été "amenée" au plus proche de la sortie ce qui signifie une disponibilité de la donnée très rapide par rapport a des structures de mémoire en matrice ou l'information doit être acheminée vers la sortie , c'est justement ce qui prend le plus de temps dans ces mémoires en matrices.

On peut résumer le procédé de lecture qui vient d'être décrit au moyen des étapes suivantes :
- une ou plusieurs opérations de décalage de l'information d'un bloc à un autre de manière à venir présenter l'information à lire dans le dernier bloc dudit circuit mémoire ;
- commande du signal EN(i) de chaque étage dudit circuit de manière à venir successivement lire chaque bit d'information en sortie dudit circuit mémoire ;
- inversion des bits de rang impair ;
- décodage de l'information de manière à restituer l'information originelle.

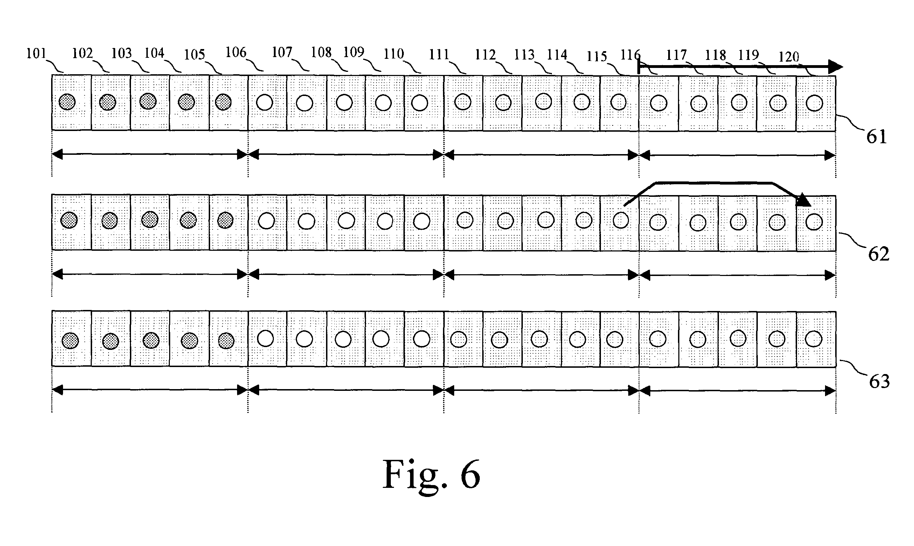

La figure 6 illustre un autre mode de réalisation de l'invention dans lequel on organise les étages 101-120 au sein de blocs de cinq étages chacun, respectivement 101-105, 106-10, 111-115 et 116-120, ce qui correspondant à un code de longueur 5. La première sous figure (référencée 61) illustre l'opération de lecture de la mémoire basée sur un décalage intervenant sur le dernier bloc de celle-ci. La sous figure 62 montre une opération de décalage visant à effectuer le transfert du contenu de l'étage 115 vers l'étage 120 du dernier bloc.

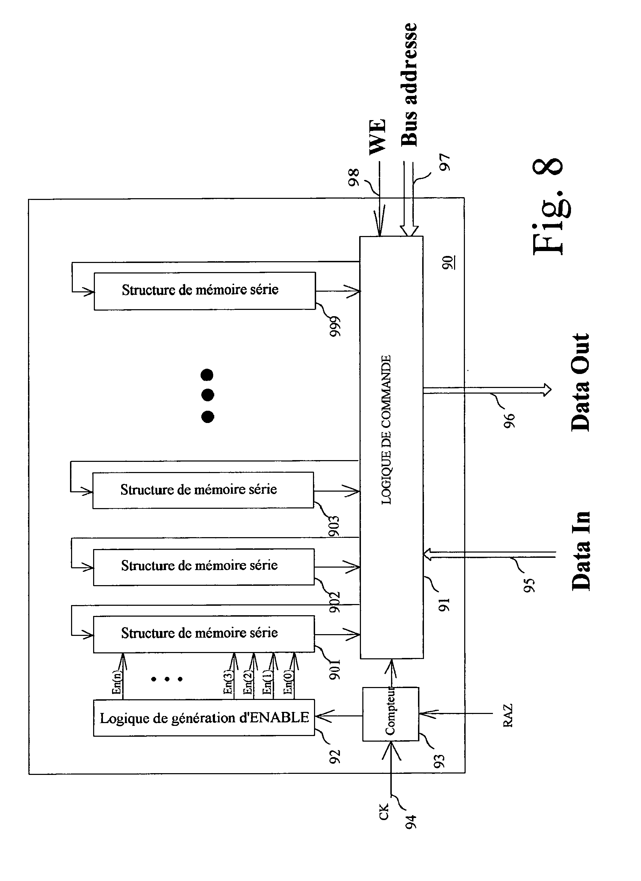

Bien qu'on ait décrit le fonctionnement d'une chaîne de stockage unique, il est à noter que l'on pourra avantageusement mettre en parallèle plusieurs chaînes de stockage qui seront commandées par les mêmes signaux EN(1) EN(n). La figure 8 illustre un circuit mémoire comportant une telle mise en parallèle de chaînes de stockages distinctes 901, 902, 903 , 999 au sein d'un même circuit 90.

Le circuit comporte en outre une logique de commande 91 qui est connectée au bus d'entrée de données 95 (DATA IN), au bus de sortie de données 96 (DATA OUT), au bus d'adresses 97 et qui reçoit en outre les signaux de commande classique, notamment le signal WE (WRITE ENABLE). Cette logique de commande 91 est connectées à l'entrée et à la sortie des chaînes de stockage 901-999 identique à celles décrites en relation avec la figure 7. On pourra toutefois intégrer les circuits encodeurs 70 et décodeurs 76 à l'intérieur de la logique de commande 91.

Le circuit comporte en outre une logique 92 de génération des signaux EN(0)-EN(n), lequel circuit 92 reçoit la valeur d'un compteur 93 recevant un signal d'horloge sur une entrée 94 ainsi qu'un signal de RAZ qui est également transmise à la logique 91.

Comme on le voit, la logique de commande 91 réalise l'interfaçage des différentes chaînes de stockages selon l'invention avec l'extérieur de la mémoire tandis que la logique 92 réalise la génération des signaux EN(1) - EN(n) de manière à permettre successivement les opérations d'écriture, de lecture et de décalage requise par les chaînes de stockage.

On a décrit le fonctionnement d'un circuit mémoire conforme à la présente invention. Il est à noter que ce circuit mémoire peut servir à la réalisation de multiples interfaces, dont un circuit de type FIFO, une mémoire à accès aléatoire etc...

## Revendications

1. Circuit mémoire comportant une chaîne d'étages élémentaires, chaque étage comportant une entrée (IN(i)), une sortie (OUT(i)) et une commande EN(i), et comportant en outre :
- un premier transistor NMOS (21(i)) présentant une grille connectée à ladite commande EN(i), une source et un drain ; et
- un second transistor NMOS (22(i)) présentant une grille connectée à ladite entrée (IN(i)), une source et un drain ;
- lesdits premier et second transistors NMOS étant connectés en série entre un premier potentiel (V_{cc}) et un second potentiel (Vₛₛ), le point milieu étant connecté à l'électrode de sortie dudit étage.
- l'entrée IN(i) de l'étage i étant connectée à la sortie OUT(i-1) de l'étage situé en amont dans ladite chaîne et la sortie OUT(i) étant connectée à l'entrée IN(i+1) de l'étage situé en aval dans la chaîne.

2. Circuit mémoire selon la revendication 1 **caractérisé en ce qu'**il comporte des moyens de codage (70) de l'information à stocker de manière à exclure le stockage de deux « 1 » consécutifs au sein de ladite chaîne d'étages.

3. Circuit mémoire comportant une chaîne d'étages élémentaires, chaque étage comportant une entrée (IN(i)), une sortie (OUT(i)) et une commande EN(i), et comportant en outre :
- un premier transistor PMOS (21 (i)) présentant une grille connectée à ladite entrée (IN(i)), une source et un drain ; et
- un second transistor PMOS (22(i)) présentant une grille connectée à ladite commande EN(i), une source et un drain ;
- lesdits premier et second transistors PMOS étant connectés en série entre un premier potentiel (V_{cc}) et un second potentiel (Vₛₛ), le point milieu étant connecté à l'électrode de sortie dudit étage.
- l'entrée IN(i) de l'étage i étant connectée à la sortie OUT(i-1) de l'étage situé en amont dans ladite chaîne et la sortie OUT(i) étant connectée à l'entrée IN(i+1) de l'étage situé en aval dans la chaîne.

4. Circuit mémoire selon la revendication 3 **caractérisé en ce qu'**il comporte des moyens de codage (70) de l'information à stocker de manière à exclure l'apparition de deux « 0 » consécutifs au sein de ladite chaîne d'étages.

5. Circuit mémoire selon l'une des revendications 1 à 4 **caractérisé en ce qu'**il comporte un circuit (92) de génération des signaux de commande EN(i) permettant de venir positionner un bit d'information à un étage donnée dans ladite chaîne d'étages.

6. Circuit mémoire selon l'une des revendications 1 à 4 **caractérisé en ce qu'**il comporte un circuit multiplexeur disposant d'une première entrée recevant l'information à stocker et d'une seconde entrée recevant la sortie du dernier étage de ladite chaîne d'étages et d'une entrée de commande permettant de commander une opération de décalage d'une information stockée dans ladite chaîne en boucle ouverte ou fermée.

7. Circuit mémoire selon l'une des revendications précédentes **caractérisé en ce qu'**il comporte au moins deux chaînes de stockage élémentaires commandées simultanément par les mêmes signaux de commande EN(i), EN(i+1)).

8. Procédé d'écriture dans un circuit mémoire tel que défini dans la revendication 1 comportant des blocs d'étages correspondant à la longueur d'un code donné, ledit code assurant le codage de l'information à stocker dans ladite chaîne de manière à exclure deux 1 logiques consécutifs ; ledit procédé d'écriture comportant les étapes suivantes :
- codage de l'information à stocker dans ledit circuit suivant le dit code,
- présentation d'un bit de l'information à stocker dans ledit circuit, sous sa forme vraie ou inversée selon son rang pair ou impair ;
- commande du signal EN(i) de chaque étage dudit circuit de manière à venir successivement positionner chaque bit d'information à un étage particulier du premier bloc ;
- opérations successive de décalage permettant de déplacer l'information d'un bloc à un autre bloc.

9. Procédé de lecture dans un circuit mémoire tel que défini dans la revendication 1 comportant des blocs d'étages correspondant à la longueur d'un code donné, ledit code assurant le codage de l'information à stocker dans ladite chaîne de manière à exclure deux 1 logiques consécutifs ; ledit procédé de lecture comportant les étapes suivantes :
- une ou plusieurs opérations de décalage de l'information d'un bloc à un autre de manière à venir présenter l'information à lire dans le dernier bloc dudit circuit mémoire ;
- commande du signal EN(i) de chaque étage dudit circuit de manière à venir successivement lire chaque bit d'information en sortie dudit circuit mémoire ;
- inversion des bits de rang impair ;
- décodage de l'information de manière à restituer l'information originelle.

10. Procédé d'écriture dans un circuit mémoire tel que défini dans la revendication 3 comportant des blocs d'étages correspondant à la longueur d'un code donné, ledit code assurant le codage de l'information à stocker dans ladite chaîne de manière à exclure deux 0 logiques consécutifs ; ledit procédé d'écriture comportant les étapes suivantes :
- codage de l'information à stocker dans ledit circuit suivant le dit code,
- présentation d'un bit de l'information à stocker dans ledit circuit, sous sa forme vraie ou inversée selon son rang pair ou impair ;
- commande du signal EN(i) de chaque étage dudit circuit de manière à venir successivement positionner chaque bit d'information à un étage particulier du premier bloc ;
- opérations successive de décalage permettant de déplacer l'information d'un bloc à un autre bloc.

11. Procédé de lecture dans un circuit mémoire tel que défini dans la revendication 3 comportant des blocs d'étages correspondant à la longueur d'un code donné, ledit code assurant le codage de l'information à stocker dans ladite chaîne de manière à exclure deux 0 logiques consécutifs ; ledit procédé de lecture comportant les étapes suivantes :
- une ou plusieurs opérations de décalage de l'information d'un bloc à un autre de manière à venir présenter l'information à lire dans le dernier bloc dudit circuit mémoire ;
- commande du signal EN(i) de chaque étage dudit circuit de manière à venir successivement lire chaque bit d'information en sortie dudit circuit mémoire ;
- inversion des bits de rang impair ;
- décodage de l'information de manière à restituer l'information originelle.
